# EUROPÄISCHE PATENTANMELDUNG

(11) **EP 1 522 866 A2**
(43) Veröffentlichungstag der Anmeldung: **13.04.2005**
(21) Anmeldenummer: 04023001.3
(22) Anmeldetag: 28.09.2004
(51) Int. Cl.: G01R 31/36

(54) **Einrichtung und Verfahren zur Bestimmung des Innenwiderstandes einer Batterie**

(30) Priorität: 08.10.2003 DE 10347317
(71) Anmelder: D-Tech GmbH, 33662 Bielefeld (DE)
(72) Erfinder: Braun, Hans-Jürgen, Dipl.-Ing., 33397 Rietberg (DE)
(74) Vertreter: Ostermann, Thomas, Dipl.-Ing.

(57) **Zusammenfassung**

Die Erfindung betrifft eine Einrichtung zur Bestimmung des Innenwiderstandes einer Batterie, insbesondere einer Starterbatterie für ein Kraftfahrzeuge, mit einer Messeinheit zum Messen eines Batteriestromwertes und eines Batteriespannungswertes, einer Verstärkereinheit zum Verstärken des Batteriestromwertes und des Batteriespannungswertes, einer Signalverarbeitungseinheit enthaltend eine Analog-Digital-Wandlereinheit zum Wandeln des analogen Batteriestromwertes und des analogen Batteriespannungswertes in einen digitalen Batteriestromwert bzw. digitalen Batteriespannungswert und eine digitale Recheneinheit zum Berechnen des Innenwiderstandes aus dem digitalen Batteriestromwert und dem digitalen Batteriespannungswert, wobei die Signalverarbeitungseinheit zwei Verarbeitungskanäle aufweist zur Verarbeitung des Batteriestromwertes und des Batteriespannungswertes, wobei die Analog-Digital-Wandlereinheit zwei identische und parallel arbeitende Analog-Digital-Wandler aufweist, an dem Eingang des einen Analog-Digital-Wandlers der Batteriespannungswert und an dem Eingang des anderen Analog-Digital-Wandlers der Batteriestromwert anliegt, in der digitalen Recheneinheit der Quotient aus dem digitalen Batteriespannungswert und dem Batteriestromwert berechnet wird und in der Signalverarbeitungseinheit eine Bandpassfiltereinheit vorgesehen ist mit jeweils einem dem Verarbeitungskanal zugeordneten Bandpassfilter.

## Beschreibung

Die Erfindung betrifft eine Einrichtung zur Bestimmung des Innenwiderstandes einer Batterie, insbesondere einer Starterbatterie für ein Kraftfahrzeuge, mit einer Messeinheit zum Messen eines Batteriestromwertes und eines Batteriespannungswertes, einer Verstärkereinheit zum Verstärken des Batteriestromwertes und des Batteriespannungswertes, einer Signalverarbeitungseinheit enthaltend eine Analog-Digital-Wandlereinheit zum Wandeln des analogen Batteriestromwertes und des analogen Batteriespannungswertes in einen digitalen Batteriestromwert bzw. digitalen Batteriespannungswert und eine digitale Recheneinheit zum Berechnen des Innenwiderstandes aus dem digitalen Batteriestromwert und dem digitalen Batteriespannungswert.

Aus der DE 102 05 120 A1 ist eine Einrichtung zur Bestimmung des Innenwiderstandes einer Batterie bekannt, die eine Messeinheit zum Messen eines Batteriestromwertes und eines Batteriespannungswertes aufweist. Der Batteriespannungswert wird an den Klemmen der Batterie abgegriffen. Der Batteriestromwert wird durch einen magnetoresistiven Stromsensor gebildet. Eine nachgeschaltete Bandpassfiltereinheit weist zwei Bandpassfilter auf, mittels derer der Batteriespannungswert bzw. der den Batteriestromwert repräsentierenden weiteren Spannungswert auf einen gewünschten Frequenzbereich eingeschränkt wird. Weiterhin umfasst die bekannte Einrichtung eine der Bandpassfiltereinheit nachgelagerte Verstärkereinheit, in dem der Batteriestromwert bzw. der Batteriespannungswert verstärkt wird. Der Verstärkereinheit ist eine Abtast- und Halteschaltung und Analog-Digital-Wandlereinheit nachgeordnet, die zusammen mit einer Rechnereinheit eine Signalverarbeitungseinheit bilden. Nach der Digitalisierung des Batteriestromwertes und des Batteriespannungswertes erfolgt in der Recheneinheit die Berechung des Innenwiderstandes durch integrative Verarbeitung von Einzelmessdaten des Batteriespannungswertes und des Batteriestromwertes in einem festgelegten Messintervall. Nachteilig an der bekannten Einrichtung ist, dass die Analog-Digital-Wandlereinheit lediglich über einen einzigen Analog-Digital-Wandler verfügt, so dass die für die Berechnung des Innenwiderstandes maßgeblichen Batteriespannungswerte und Batteriestromwerte nacheinander der Recheneinheit zur Verfügung gestellt werden.

Aufgabe der vorliegenden Erfindung ist es, eine Einrichtung und ein Verfahren zur Bestimmung des Innenwiderstandes einer Batterie derart anzugeben, dass die Ermittlung des Innenwiderstandes verbessert wird.

Zur Lösung dieser Aufgabe ist die Erfindung in Verbindung mit dem Oberbegriff des Patentanspruchs 1 dadurch gekennzeichnet, dass die Signalverarbeitungseinheit zwei Verarbeitungskanäle aufweist zur Verarbeitung des Batteriestromwertes und des Batteriespannungswertes, wobei die Analog-Digital-Wandlereinheit über zwei identische und parallel arbeitende Analog-Digital-Wandler aufweist, dass an dem Eingang des einen Analog-Digital-Wandlers der Batteriespannungswert und an dem Eingang des anderen Analog-Digital-Wandlers der Batteriestromwert anliegt, dass in der digitalen Recheneinheit der Quotient aus dem digitalen Batteriespannungswert und dem Batteriestromwert berechnet wird und dass in der Signalverarbeitungseinheit eine Bandpassfiltereinheit vorgesehen ist mit jeweils einem dem Verarbeitungskanal zugeordneten Bandpassfilter.

Nach der Erfindung erfolgt die Berechnung des Innenwiderstandes durch eine Quotientenbildung aus einem digitalisierten Batteriespannungswertes und einem digitalen Stromwertes. Die Ermittlung und Verarbeitung des Batteriespannungswertes einerseits und des Batteriestromwertes andererseits erfolgt in getrennten Kanälen unabhängig von der Erfassung des Messwertes bis zur Digitalisierung desselben. Erst in der digitalen Recheneinheit erfolgt durch Quotientenbildung eine Verknüpfung der beiden Messwerte. Durch die Verarbeitung der beiden Messwerte in getrennten Kanälen kann eine optimale Aufbereitung derselben in Abhängigkeit von der Signalform bzw. Signalgröße ermöglicht werden. Durch die Integration einer Bandpassfiltereinheit in die Signalverarbeitungseinheit kann ein toleranzloser Gleichlauf (Mismatch) beider Verarbeitungskanäle gewährleistet sein.

Die Bandpassfiltereinheit ist vorteilhaft zusammen mit der Verstärkereinheit, der Analog-Digital-Wandlereinheit und der digitalen Recheneinheit auf einem gemeinsamen Halbleiterbaustein integriert ausgebildet. Die erfindungsgemäße Einrichtung ist daher kompakt und platzsparend aufgebaut.

Nach einer Weiterbildung der Erfindung werden die digitalisierten Batteriemesswerte synchron der digitalen Recheneinheit zur Verfügung gestellt, so dass eine einfache Berechung durch Quotientenbildung derselben erfolgen kann.

Nach einer Weiterbildung der Erfindung ist das Bandpassfilter als ein Tiefpassfilter ausgebildet, das eine genauere Erfassung der gemittelten Batteriemesswerte ermöglicht.

Nach einer Weiterbildung der Erfindung ist der Analog-Digital-Wandler als ein Delta-Sigma-Wandler ausgebildet, der wenig anfällig gegen überlagerte Störungen ist. Eine Abtast- und Halteschaltung ist nicht erforderlich.

Zur Lösung der Aufgabe ist das erfindungsgemäße Verfahren in Verbindung mit dem Oberbegriff des Patentanspruchs 9 dadurch gekennzeichnet, dass das Batteriestromsignal und das Batteriespannungssignal während oder nach der Digitalisierung derselben mittels einer Bandpassfiltereinheit auf ein vorgegebenes Filterband gefiltert werden.

Vorteilhaft ermöglicht das erfindungsgemäße Verfahren eine verbesserte Nutzsignalfilterung. Zum einen kann eine Bandpassfilterung während des Analog-Digital-Umsetzens oder nach dem Analog-Digital-Umsetzen erfolgen. Vorteilhaft wird hierdurch ein komplettes "Matching" erzielt, was das Signalergebnis wesentlich verbessert.

Nach einer Weiterbildung des erfindungsgemäßen Verfahren können die Batteriespannungs- und Batteriestromsignale nach dem Digitalisieren in dem Analog-Digital-Umsetzer einem Dezimationsfilter zugeführt werden, in dem die Abtastwerte um einen Dezimationsfaktor verringert werden. Die Dezimationsfilterung kann optional auch gleichzeitig mit einer Bandpassfilterung erfolgen.

Nach einer Weiterbildung des erfindungsgemäßen Verfahrens werden die Signale vor dem Zuführen zu dem Dezimationsfilter und/oder vor dem Zuführen zu dem Analog-Digital-Umsetzer einem Anti-Alias-Filter zugeführt, so dass die störenden Aliasfrequenzen herausgefiltert werden.

Weitere Vorteile der Erfindung ergeben sich aus den weiteren Unteransprüchen.

Ein Ausführungsbeispiel der Erfindung wird nachfolgend anhand der Zeichnungen näher erläutert.

Es zeigen:

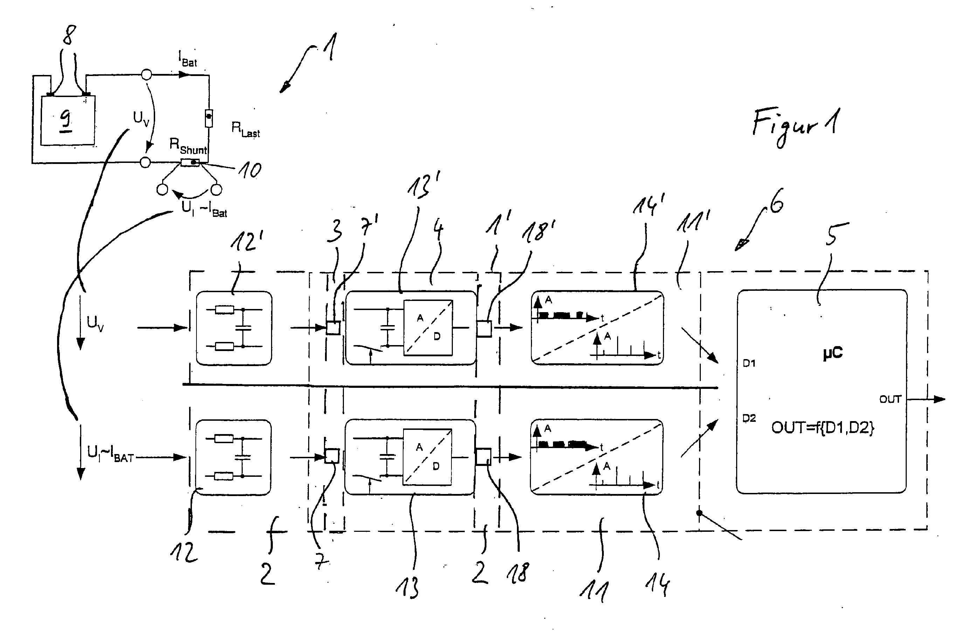

- Figur 1: ein Blockschaltbild einer erfindungsgemäßen Einrichtung zur Bestimmung des Innenwiderstandes einer Batterie,
- Figur 2: ein Schaubild eines Signalspektrums am Eingang einer Signalverarbeitungseinheit,
- Figur 3: ein Schaubild eines Signalspektrums am Eingang der Signalverarbeitungseinheit, bei dem die analogen Signale vorgefiltert sind,
- Figur 4a: ein Schaubild eines Spektrums des Signals, das gleichzeitig digitalisiert und mit einem Bandpassfilter beaufschlagt worden ist,
- Figur 4b: ein Schaubild des Signalspektrums nach der Analog-Digital-Umsetzung, wobei mittels eines Dezimationsfilters die Daten reduziert worden sind,
- Figur 5a: ein Schaubild eines Signals, das mittels eines übertastenden Analog-Digital-Umsetzers digitalisiert worden ist und
- Figur 5b: ein Schaubild eines Signals, das zur Datenreduktion einem Dezimationsfilter zugeführt und mit einem Bandpassfilter beaufschlagt worden ist.

Eine erfindungsgemäße Einrichtung zur Bestimmung des Innenwiderstandes einer Batterie, nämlich einer Starterbatterie für ein Kraftfahrzeug, besteht im wesentlichen aus einer Messeinheit 1 zum Messen eines Batteriestromwertes I_{Bat} und eines Batteriespannungswertes U_{Hat} und einer Signalverarbeitungseinheit 1', die eine Bandpassfiltereinheit 2, eine Verstärkereinheit 3, eine Analog-Digital-Wandlereinheit 4 und eine Recheneinheit 5 umfasst.

Die genannte Bandpassfiltereinheit 2, Verstärkereinheit 3, Analog-Digital-Wandlereinheit 4 und Recheneinheit 5 befinden sich auf einem gemeinsamen Halbleiterbaustein 6 (Chip). Der Halbleiterbaustein 6 ist als ASIC-Baustein ausgebildet, wobei die Recheneinheit 5 einen Mikroprozessor aufweist zur Steuerung der ermittelten Daten und Berechnung der gewünschten Informationen.

Die Messeinheit 1 umfasst ein nicht dargestelltes Spannungsmesswerk zur Ermittlung des Batteriespannungswertes, wobei hierzu die Anschlüsse des Spannungsmesswerkes an Klemmen 8 einer Starterbatterie 9 angeschlossen werden. Ferner umfasst die Messeinheit 1 einen Shunt-Widerstand R_{Shunt}, an dem eine den Batteriestrom I_{Bat} repräsentierende Spannung U_{Bat} ermittelt wird.

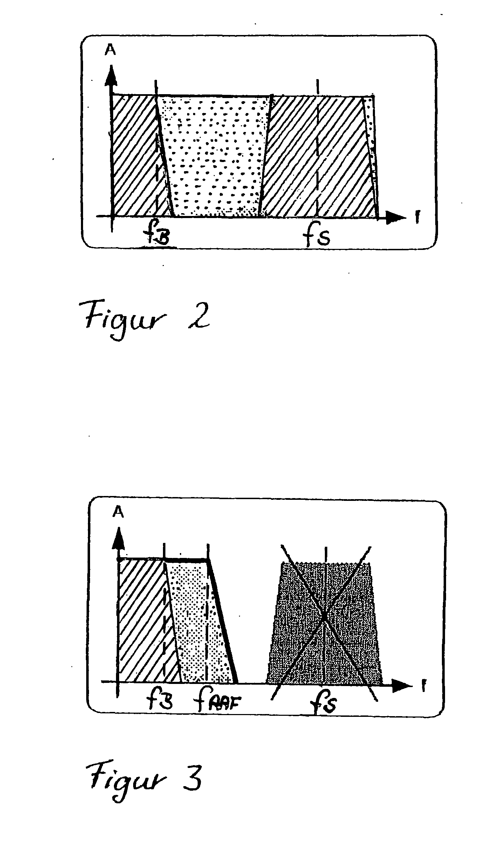

Der so ermittelte Batteriestromwert I_{Bat} und Batteriespannungswert U_{Bat} ergeben jeweils ein Eingangsspektrum, wie es in Figur 2 dargestellt ist.

Das Batteriestromsignal I_{Bat} und das Batteriespannungssignal U_{Bat} werden jeweils in getrennten Kanälen 11, 11' einem Anti-Alias-Filter 12, 12' zugeführt, in dem die höher frequenten Anteile herausgefiltert werden bis zu einer Grenzfrequenz f_{AAF}. Der Anti-Alias-Filter 12, 12' ist Bestandteil der Bandpassfiltereinheit 2, die auf dem Halbleiterbaustein 6 angeordnet ist.

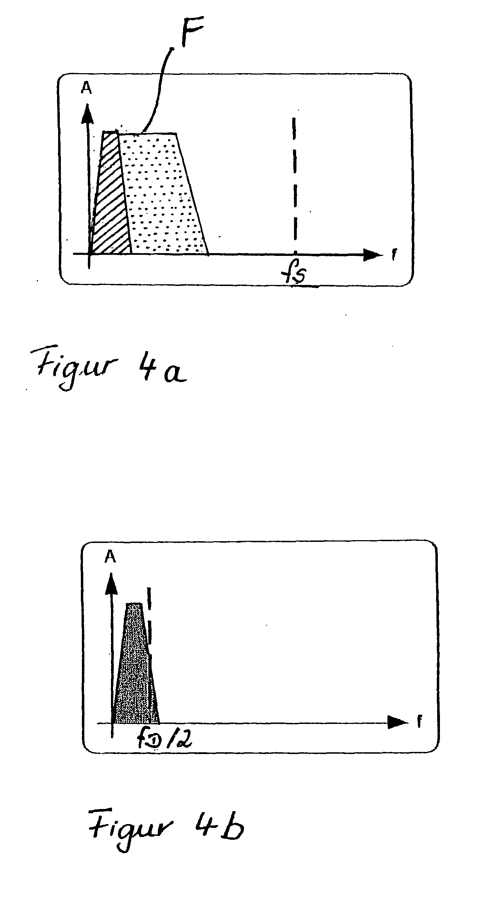

Nach einer ersten Ausführungsform der Erfindung gemäß den Figuren 4a und 4b werden die Batteriestromsignale I_{Bat} und Batteriespannungssignale U_{Bat} nach Verstärkung in dem Verstärker 7, 7' einer Verstärkereinheit 3 jeweils einem Analog-Digital-Wandler 13, 13' zugeführt, in dem gleichzeitig eine Nutzsignalfilterung erfolgt. Die Analog-Digital-Wandler 13, 13' sind jeweils als Delta-Sigma-Wandler ausgebildet, die eine hochauflösende Verarbeitung der Signale I_{Bat},U_{Bat} ermöglichen. Die Delta-Sigma-Wandler 13, 13' erzeugen synchron die digitalisierten Batteristromwerte I_{Bat} und Batteriespannungswerte U_{Bat}. Mit dem Digitalisieren der Signale erfolgt eine Filterung derselben mit einer Hochund/oder Tiefpasscharakteristik. Im vorliegenden Ausführungsbeispiel erfolgt eine Tiefpassfilterung, so dass sich ein Filterband F gemäß Figur 4a ergibt.

In einem darauffolgenden Signalverarbeitungsschritt können die Signale I_{Bat}, U_{Bat} kanalweise einem Dezimationsfilter 14, 14' zugeführt werden zur Reduktion der Datenmenge. vorzugsweise ist vor den Dezimationsfiltern 14, 14' ein nicht dargestellter Anti-Alias-Filter positioniert, um ein Spiegeln des über der halben Abtastfrequenz f_{D/2} liegenden Frequenzanteile in das Nutzsignal zu verhindern.

Nach der Signalaufbereitung der Batteriespannungssignale U_{Bat} und Batteriestromsignale I_{Bat} in dem Dezimationsfilter 14, 14' werden die Signale jeweils als Eingangsgröße D1, D2 der Recheneinheit 5 zugeführt, wobei durch Quotientenbildung der zugefügten Signale U_{Bat}, I_{Bat} der Innenwiderstand der Batterie berechnet wird. Der ermittelte Innenwiderstandswert kann dann in einem Speicher der Recheneinheit 5 abgespeichert werden und gegebenenfalls mit weiteren Innenwiderstandswerten gemittelt werden.

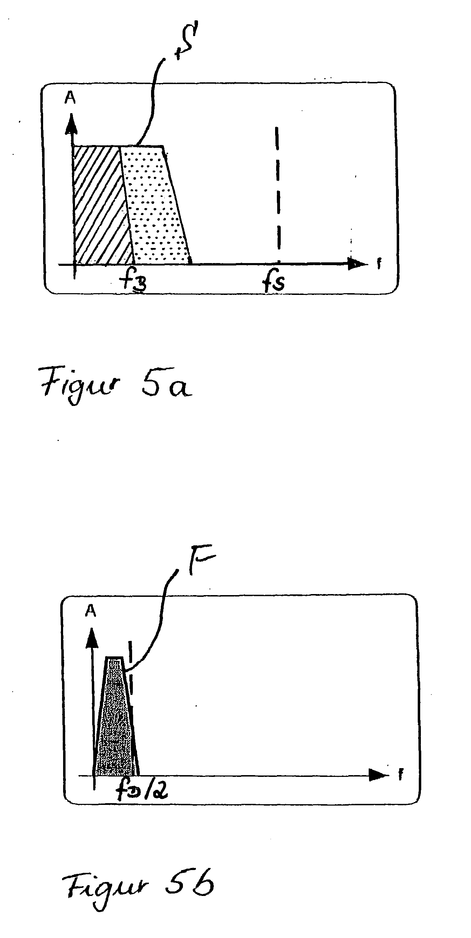

Nach einer alternativen Ausführungsform der Erfindung gemäß den Figuren 5a und 5b kann die Nutzsignalfilterung nach der Analog-Digital-Umsetzung erfolgen. In einem sich an die analoge Vorfilterung des Eingangsspektrums gemäß Figur 3 anschließenden Analog-Digital-Umsetzschritt wird ein Signalband S gemäß Figur 5a erzeugt. In einem nachfolgenden Schritt werden die Signale U_{Bat}, I_{Bat} jeweils einem Bandpassfilter, vorzugsweise einem Tiefpassfilter 18, 18', der Bandpassfiltereinheit 2 zugeführt, so dass sich gemäß Figur 5b ein Filterband F ergibt. Dieses kann durch Anwendung eines Dezimationsfilters modifiziert werden, siehe Figur 5b. Vorzugsweise erfolgt die Bandpassfilterung und die Dezimationsfilterung gleichzeitig. Sie kann jedoch auch nacheinander erfolgen.

## Patentansprüche

1. Einrichtung zur Bestimmung des Innenwiderstandes einer Batterie, insbesondere einer Starterbatterie für ein Kraftfahrzeuge, mit
- einer Messeinheit zum Messen eines Batteriestromwertes und eines Batteriespannungswertes,
- einer Verstärkereinheit zum Verstärken des Batteriestromwertes und des Batteriespannungswertes,
- einer Signalverarbeitungseinheit enthaltend eine Analog-Digital-Wandlereinheit zum Wandeln des analogen Batteriestromwertes und des analogen Batteriespannungswertes in einen digitalen Batteriestromwert bzw. digitalen Batteriespannungswert und eine digitale Recheneinheit zum Berechnen des Innenwiderstandes aus dem digitalen Batteriestromwert und dem digitalen Batteriespannungswert,
**dadurch gekennzeichnet, dass** die Signalverarbeitungseinheit (1') zwei Verarbeitungskanäle (11, 11') aufweist zur Verarbeitung des Batteriestromwertes und des Batteriespannungswertes, wobei die Analog-Digital-Wandlereinheit (4) über zwei identische und parallel arbeitende Analog-Digital-Wandler (13, 13') aufweist, dass an dem Eingang des einen Analog-Digital-Wandlers (13) der Batteriespannungswert (U_{Bat}) und an dem Eingang des anderen Analog-Digital-Wandlers (13') der Batteriestromwert (I_{Bat}) anliegt, dass in der digitalen Recheneinheit (5) der Quotient aus dem digitalen Batteriespannungswert (U_{Bat}) und dem Batteriestromwert (I_{Bat}) berechnet wird und dass in der Signalverarbeitungseinheit (1') eine Bandpassfiltereinheit (2) vorgesehen ist mit jeweils einem dem Verarbeitungskanal (11, 11') zugeordneten Bandpassfilter (12, 12').

2. Einrichtung nach Anspruch 1, **dadurch gekennzeichnet, dass** die in der Messeinheit (1) getrennt ermittelten Batteriespannungswerte (U_{Bat}) und Batteriestromwerte (I_{Bat}) über die getrennten Verarbeitungskanäle (11, 11') aufbereitet werden, bis sie in der digitalen Recheneinheit (5) zur Quotientenbildung zusammengeführt werden.

3. Einrichtung nach Anspruch 1 oder 2, **dadurch gekennzeichnet, dass** der digitalisierte Batteriespannungswert (U_{Bat}) und der digitalisierte Batteriestromwert (I_{Bat}) synchron der digitalen Recheneinheit (5) zugeführt werden.

4. Einrichtung nach einem der Ansprüche 1 bis 3, **dadurch gekennzeichnet, dass** die Bandpassfilter (12, 12') als Tiefpassfilter (12, 12') ausgebildet ist und dass die Bandpassfilter (12, 12') jeweils in den Analog-Digital-Wandlern (13, 13') integriert sind oder dass die Bandpassfilter (12, 12') den Analog-Digital-Wandlern (13, 13') nachgeordnet sind.

5. Einrichtung nach einem der Ansprüche 1 bis 4, **dadurch gekennzeichnet, dass** die Analog-Digital-Wandler jeweils als Delta-Sigma-Wandler (13, 13') ausgebildet sind.

6. Einrichtung nach einem der Ansprüche 1 bis 5, **dadurch gekennzeichnet, dass** die digitale Recheneinheit (5) einen Mikrocontroller mit einem Speicher zur Aufnahme der berechneten Innenwiderstandswerte aufweist.

7. Einrichtung nach einem der Ansprüche 1 bis 6, **dadurch gekennzeichnet, dass** die berechneten Innenwiderstandswerte in der Recheneinheit (5) gemittelt werden.

8. Einrichtung nach einem der Ansprüche 1 bis 7, **dadurch gekennzeichnet, dass** die Signalverarbeitungseinheit (1') auf einem Halbleiterbaustein integriert ausgebildet ist und dass der Halbleiterbaustein als ein ASIC-Baustein ausgeführt ist.

9. Verfahren zur Bestimmung des Innenwiderstandes einer Batterie, insbesondere einer Starterbatterie für ein Kraftfahrzeug, wobei ein Batteriestromsignal und ein Batteriespannungssignal gemessen werden, nachfolgend das Batteriestromsignal und das Batteriespannungssignal digitalisiert und aus den digitalisierten Signalen der Innenwiderstand der Batterie berechnet wird, **dadurch gekennzeichnet, dass** das Batteriestromsignal (I_{Bat}) und das Batteriespannungssignal (U_{Bat}) während oder nach der Digitalisierung derselben mittels einer Bandpassfiltereinheit (2) auf ein vorgegebenes Filterband (F) gefiltert werden.

10. Verfahren nach Anspruch 9, **dadurch gekennzeichnet, dass** das digitalisierte Batteriestromsignal (I_{Bat}) und das digitalisierte Batteriespannungssignal (U_{Bat}) einem Dezimationsfilter (14, 14') zugeführt werden.

11. Verfahren nach Anspruch 9 oder 10, **dadurch gekennzeichnet, dass** das Batteriestromsignal (I_{Bat}) und das Batteriespannungssignal (U_{Bat}) vor der getrennten Zuführung zu einem Analog-Digital-Wandler (13, 13') und/oder dem Zuführen zu dem Dezimationsfilter (14, 14') jeweils einem Anti-Alias-Filter zugeführt werden.
